# FASCICULE DE BREVET EUROPEEN

(11) **EP 1 473 381 B1**
(45) Date de publication et mention de la délivrance du brevet: **18.07.2007**
(21) Numéro de dépôt: 04354017.8
(22) Date de dépôt: 02.04.2004
(51) Int. Cl.: C23C 14/22, C23C 16/52, C23C 26/00

(54) **Procédé destiné à éviter le dépôt de particules contaminatrices sur la surface d'un micro-composant, dispositif de stockage d'un micro-composant et dispositif de dépôt de couches minces**
Verfahren zur Vermeidung von Ablagerungen von Verunreinigungsteilchen auf die Oberfläche eines Mikrobauteils, Aufbewahrungsvorrichtung für ein Mikrobauteil und Vorrichtung zur Abscheidung von dünnen Schichten
Method for preventing the deposition of contaminating particles on the surface of a microcomponent, Storage device for a microcomponent and thin film deposition device

(30) Priorité: 28.04.2003 FR 0305169
(43) Date de publication de la demande: 03.11.2004
(73) Titulaire: Commissariat à l'Energie Atomique, 75752 Paris 15ème (FR)
(72) Inventeur: Quesnel, Etienne, 38240 Meylan (FR); Muffato, Viviane, 38450 Le Gua (FR)
(74) Mandataire: Jouvray, Marie-Andrée

(56) Documents cités:
- US-A- 4 392 453
- PATENT ABSTRACTS OF JAPAN vol. 1996, no. 03, 29 mars 1996 (1996-03-29) & JP 07 291790 A (NIPPON STEEL CORP), 7 novembre 1995 (1995-11-07)
- KOJIMA M ET AL: "Impurity generation for low energy range of ion bombardment and its transport in a plasma" JOURNAL OF NUCLEAR MATERIALS, AMSTERDAM, NL, vol. 241-243, 11 février 1997 (1997-02-11), pages 1248-1252, XP004403178 ISSN: 0022-3115
- WALTON C C ET AL: "EXTREME ULTRAVIOLET LITHOGRAPHY - REFLECTIVE MASK TECHNOLOGY" PROCEEDINGS OF THE SPIE, SPIE, BELLINGHAM, VA, US, vol. 3997, 28 février 2000 (2000-02-28), pages 496-507, XP009016269 ISSN: 0277-786X
- HUE J ET AL: "Reduction of defect density on blanks: application to the extreme ultraviolet lithography" MICROELECTRONIC ENGINEERING, ELSEVIER PUBLISHERS BV., AMSTERDAM, NL, vol. 61-62, juillet 2002 (2002-07), pages 203-211, XP004360534 ISSN: 0167-9317

## Description

### Domaine technique de l'invention

L'invention concerne un procédé destiné à éviter le dépôt de premières particules polarisées issues d'au moins une source de contamination, sur la surface libre d'un micro-composant disposé dans une chambre sous vide.

L'invention concerne également un dispositif de stockage mettant en oeuvre un tel procédé et comportant une chambre sous vide dans laquelle est disposé au moins un micro-composant.

L'invention concerne également un dispositif de dépôt de couches minces mettant en oeuvre un tel procédé et comportant une chambre sous vide dans laquelle est disposé un micro-composant comportant au moins un substrat et des moyens de pulvérisation d'un flux de matière destinée à former au moins une couche mince à la surface du micro-composant.

### État de la technique

Les couches minces, notamment utilisées dans des applications optiques ou mécaniques, doivent comporter un nombre de défauts limité et les défauts tolérés doivent avoir une taille critique. En effet, les défauts formés dans une couche mince peuvent dégrader la couche en fonctionnement ou même l'empêcher de fonctionner. Ainsi, dans des couches ayant une fonction mécanique telles que des couches anti-usure, anti-corrosion ou lubrifiantes, les défauts constituent des points de faiblesse à partir desquels s'amorce l'usure de la couche.

De même, les défauts formés dans des couches optiques peuvent engendrer des disfonctionnements. À titre d'exemple, un masque de lithographie utilisé en Extrême Ultraviolet (EUV), dans une gamme de longueurs d'onde comprises entre 10nm et 20 nm, comporte un substrat sur lequel sont déposées successivement une pluralité de couches superposées formant un réflecteur, une couche de protection, puis une couche tampon et une couche absorbante. Des motifs sont gravés dans la couche tampon et la couche absorbante pour être, ensuite, imagés sur une plaquette de silicium à insoler pour former un circuit imprimé. Les défauts présents sur la surface du masque ou dans les premières couches du réflecteur risquent de perturber l'image du motif projeté. Cette perturbation peut créer, au niveau du circuit imprimé, sur le silicium, des coupures de piste ou des défauts dans les motifs du circuit.

De plus, la taille des défauts joue, également, un rôle critique dans les masques de lithographie EUV. En effet, les systèmes de projection lithographique EUV fonctionnent avec un facteur 4 de réduction optique. Ainsi, pour réaliser des circuits imprimés ayant des dimensions critiques de 30nm à 50nm, la taille des motifs formés dans la couche absorbante et dans la couche tampon doit être comprise entre 120nm à 200nm. Ainsi, le masque ne doit pas contenir des défauts ayant un diamètre supérieur à 50nm.

Une partie des défauts des couches minces est, le plus souvent, formée par des particules contaminatrices qui ont été générées au cours du procédé de dépôt des couches minces, par exemple lors d'un procédé par évaporation sous vide, ou bien qui se sont déposées à la surface d'un micro-composant lors de son stockage. À titre d'exemple, pour un masque de lithographie EUV, l'étape critique est la réalisation du réflecteur, c'est-à-dire le dépôt des couches minces superposées, le plus souvent en molybdène et en silicium, formant le réflecteur. Le réflecteur requiert, généralement, un taux de défauts ayant une taille supérieure à 50nm, inférieur à 0,003 défauts par cm². Or les techniques de dépôt des couches minces formant le réflecteur sont connues pour générer des défauts. En effet, même la technique de dépôt par faisceau d'ions, plus connue sous le nom de pulvérisation IBS (« Ion Beam Sputtering) et généralement utilisée pour réaliser le réflecteur d'un masque EUV, n'est pas satisfaisante. La source de pulvérisation générant elle-même des particules contaminatrices ayant une taille inférieure à 150nm, il est, en effet, extrêmement difficile de limiter les densités de défaut au taux imposé et d'une manière reproductible.

C.C. Walton et al, dans l'article « Extreme Ultraviolet Lithography-reflective mask technology » (Emerging Lithographic Technologies IV, Proceedings of SPIE, vol 3997, 2000, pages 496-507) ont proposé des changements dans le procédé de pulvérisation « IBS » destiné à réaliser un dépôt de couches minces destinées à former le réflecteur d'un masque de lithographie EUV. Ainsi pour réduire les défauts et améliorer les dispositifs de dépôt, ils proposent de polir mécaniquement et graver les cibles de pulvérisation de molybdène et de silicium, d'installer des boucliers métalliques sur le canon ionique et sur les parois de la chambre, d'installer un système linéaire rigide dans le système de dépôt pour fournir une surface de capture pour les particules parasites issues de la cible de pulvérisation... Ces modifications ne permettent cependant pas d'obtenir, de manière reproductible le taux de défauts requis pour les masques de lithographie EUV.

### Objet de l'invention

L'invention a pour but de réduire, de manière efficace, simple et reproductible, le risque de contaminer, par dépôt de particules parasites, la surface libre d'un micro-composant disposée dans une chambre sous vide.

Selon l'invention, ce but est atteint par le fait que le procédé consiste à pulvériser, entre la source de contamination et le micro-composant, un faisceau de secondes particules dont au moins une partie a une polarité inverse à celle des premières particules, de manière à entraîner les premières particules à l'écart du micro-composant, vers un élément collecteur.

Selon un développement de l'invention, le faisceau de secondes particules est un plasma.

Selon un mode de réalisation préférentiel, le micro-composant comporte un substrat sur lequel est destinée à être déposée au moins une couche mince et les premières particules sont entraînées par un flux de matière pulvérisée destiné à former ladite couche mince, le faisceau de secondes particules traversant le flux de matière pulvérisée en amont du micro-composant.

Selon une autre caractéristique de l'invention, le flux de matière pulvérisée est formé par le bombardement d'une cible par un plasma de pulvérisation, le faisceau de secondes particules pouvant traverser simultanément le plasma de pulvérisation et le flux de matière pulvérisée.

L'invention a également pour but un dispositif de stockage destiné à stocker au moins un micro-composant, en protégeant efficacement et simplement sa surface d'un éventuel dépôt de particules contaminatrices.

Selon l'invention, ce but est atteint par le fait que le dispositif comporte une source émettant le faisceau de secondes particules parallèlement et à proximité de la surface libre du micro-composant.

L'invention a également pour but un dispositif de dépôt de couches minces limitant efficacement le risque de contamination de la couche mince par dépôt de particules contaminatrices.

Selon l'invention, ce but est atteint par le fait que le dispositif de dépôt de couches minces comporte une source émettant le faisceau de secondes particules en direction du flux de matière, de manière à ce qu'il entraîne les premières particules contenues dans le flux, à l'écart du micro-composant.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
La figure 1 représente schématiquement un premier mode de réalisation d'un dispositif de dépôt de couches minces selon l'invention.
La figure 2 représente un second mode de réalisation d'un dispositif de dépôt de couches minces selon l'invention.
La figure 3 représente une variante de réalisation du dispositif de dépôt de couches minces selon la figure 2.
La figure 4 représente schématiquement un mode particulier de réalisation d'un dispositif de stockage selon l'invention.

### Description de modes particuliers de réalisation.

Selon l'invention, un procédé destiné à éviter le dépôt de particules contaminatrices polarisées, issues d'une source de contamination, sur la surface libre d'un micro-composant consiste à pulvériser un faisceau de particules dont au moins une partie a une polarité inverse à celle des particules contaminatrices. Le micro-composant est disposé dans une chambre sous vide. Le faisceau de particules est pulvérisé entre la source de contamination et le micro-composant et il est destiné à entraîner les particules contaminatrices à l'écart du micro-composant, vers un élément collecteur. Le faisceau de particules est, de préférence, un plasma.

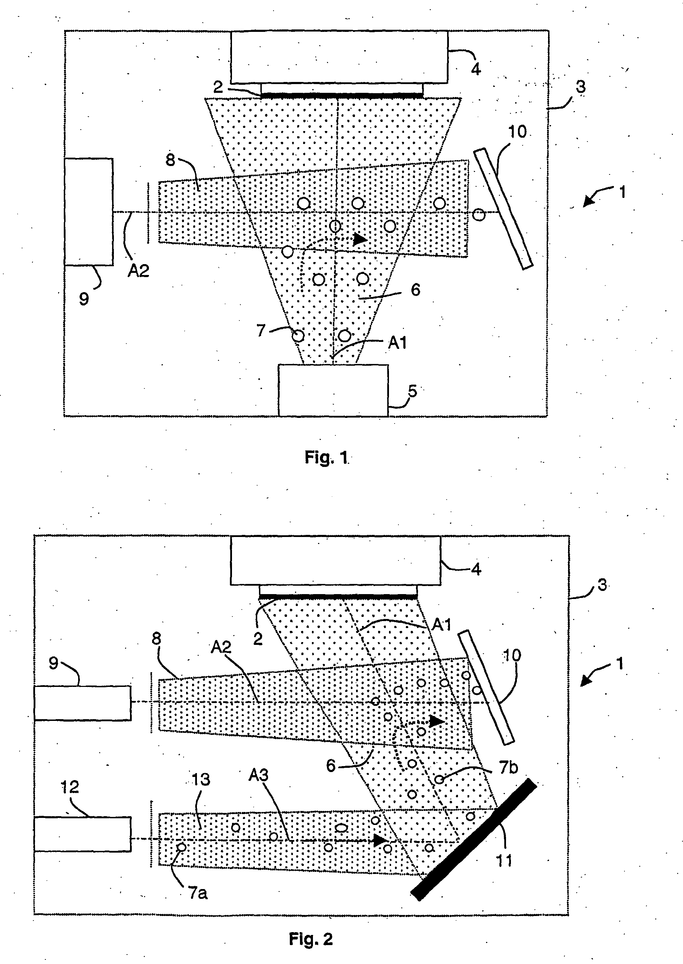

Ainsi, selon la figure 1, un dispositif 1 mettant en oeuvre un tel procédé est destiné à déposer au moins une couche mince sur un substrat 2, de manière à former un micro-composant. Le dispositif 1 comporte une chambre sous vide 3 dans laquelle sont respectivement disposés, sur deux parois opposées, un porte-susbtrat 4 comportant le substrat 2 et une source 5 destinée à pulvériser, selon un axe A1, un flux 6 de matière atomique ou moléculaire, en direction de la surface libre du substrat 2. La matière pulvérisée est destinée à former une couche mince sur la surface libre du substrat.

La source 5 peut être de tout type selon le procédé de dépôt utilisé. Ainsi, elle peut être, par exemple, une cathode de pulvérisation cathodique dans le cas d'un dépôt par pulvérisation cathodique, une cible de pulvérisation dans le cas d'un dépôt par faisceau d'ions (IBS) ou bien encore une source d'évaporation par effet Joule dans le cas d'un dépôt par évaporation thermique par effet Joule. La source 5 peut également être une source émettant un faisceau d'électrons ou un faisceau laser ou bien être une source pour réaliser un dépôt chimique en phase vapeur. En fonctionnement, la source 5 émet des particules contaminatrices 7 polarisées qui sont entraînées avec le flux de matière pulvérisée et qui sont susceptibles de contaminer la surface libre du substrat 2.

Pour éviter que des particules contaminatrices 7 ne se déposent à la surface libre du substrat 2, un faisceau 8 de particules, issu d'une source ionique 9, est pulvérisé, selon un axe A2, de manière à traverser le flux de matière pulvérisée 6, en amont du substrat. L'axe A2 est perpendiculaire à l'axe A1. Au moins une partie des particules issues de la source ionique 9 a une polarité inverse à celle des particules contaminatrices 7, de manière à entraîner les particules contaminatrices 7 vers un élément collecteur 10 disposé sur l'axe A2, à l'écart du substrat 2. L'entraînement des particules contaminatrices 7 vers la plaque collectrice 10 est représenté par une flèche en traits pointillés à la figure 1. La matière pulvérisée destinée à former la couche mince étant non polarisée, celle-ci n'est pas entraînée par le faisceau 8 de particules. Elle traverse donc le faisceau 8 de particules et se dépose sur la surface libre du substrat pour former la couche mince.

L'élément collecteur peut être, par exemple, une plaque collectrice et le faisceau 8 de particules est, de préférence, un plasma constitué d'ions positifs et d'électrons de neutralisation. La proportion d'ions et d'électrons est généralement telle que le plasma reste globalement neutre. Cependant, localement, le plasma n'est pas neutre. Ainsi, les particules contaminatrices 7 sont piégées lors de la traversée du plasma, notamment par la force d'entraînement exercée par les ions du plasma sur les particules contaminatrices 7. Cette force est de type balistique avec transfert de quantité de mouvement des ions aux particules contaminatrices 7. Les particules contaminatrices étant chargées soit positivement soit négativement, l'interaction électrique entre le plasma et les particules contaminatrices 7 renforce également le piégeage des particules contaminatrices 7. Le gaz ou le mélange de gaz, issu de la source ionique 9 et formant le plasma, sont, de préférence, choisis parmi des gaz légers tels que le néon, l'hélium, l'hydrogène ou d'autres gaz rares tels que l'argon ou le xénon. Ainsi, le plasma généré n'induit pas une contamination supplémentaire lors de la pulvérisation de l'élément collecteur 10. De même, pour éviter une telle contamination, la tension d'extraction des ions appliquée à la source ionique, c'est-à-dire la tension destinée à générer le plasma est, de préférence, comprise entre 50 Volts et 200 Volts. Ceci permet d'obtenir un plasma extrait à basse énergie. Il est également possible d'utiliser un plasma à haute énergie avec le collecteur 10 polarisé positivement pour freiner les ions incidents.

Le procédé utilisé pour former la première couche mince sur le substrat 2 est également utilisé pour le dépôt de couches minces successives. Dans ce cas, le faisceau de particules doit entraîner les particules contaminatrices 7 à l'écart de la surface libre du micro-composant formé par le substrat et les couches minces précédemment formées. Ainsi, par surface libre du micro-composant, on entend soit la surface du substrat 2 lorsque l'on réalise un premier dépôt de couche mince sur le substrat 2, soit la surface libre d'une couche mince déjà déposée sur le substrat 2.

Dans le cas d'un dépôt de couches minces par faisceau d'ions (IBS), le flux de matière pulvérisée 6 est formé par le bombardement d'une cible 11 par un plasma de pulvérisation 12 (figure 2). Un canon de pulvérisation 12 pulvérise, selon un axe A3, un plasma de pulvérisation 13. Le canon de pulvérisation génère cependant des particules contaminatrices 7a polarisées qui sont alors entraînées dans le plasma de pulvérisation 13. Lorsque le plasma de pulvérisation 13 bombarde la cible 11, celle-ci émet, selon l'axe A1, un flux 6 de matière pulvérisée, moléculaire ou atomique, en direction du substrat 2. La cible 11 génère également des particules contaminatrices polarisées 7b. Celles-ci sont entraînées, avec les particules contaminatrices 7a, dans le flux 6 de matière pulvérisée, jusqu'à ce que les particules contaminatrices 7a et 7b rencontrent un plasma 8 issu d'une source ionique 9 et traversant le flux 6 de matière pulvérisée.

Le plasma 8, faisant écran, entraîne les particules contaminatrices vers l'élément collecteur 10 tout en laissant passer la matière pulvérisée. Sur la figure 2, l'axe A3 du plasma de pulvérisation 13 est parallèle à l'axe A2 du plasma 8 et l'angle α formé par les axes A1 et A3 est un angle aigu. L'entraînement des particules contaminatrices 7a et 7b est représenté, à la figure 2, par des flèches en traits pointillés. Ce mode de réalisation est, particulièrement, adapté au dépôt de couches minces de molybdène et de silicium, telles que celles qui sont destinées à former le réflecteur d'un masque de lithographie EUV fonctionnant à une longueur d'onde de 13,7nm.

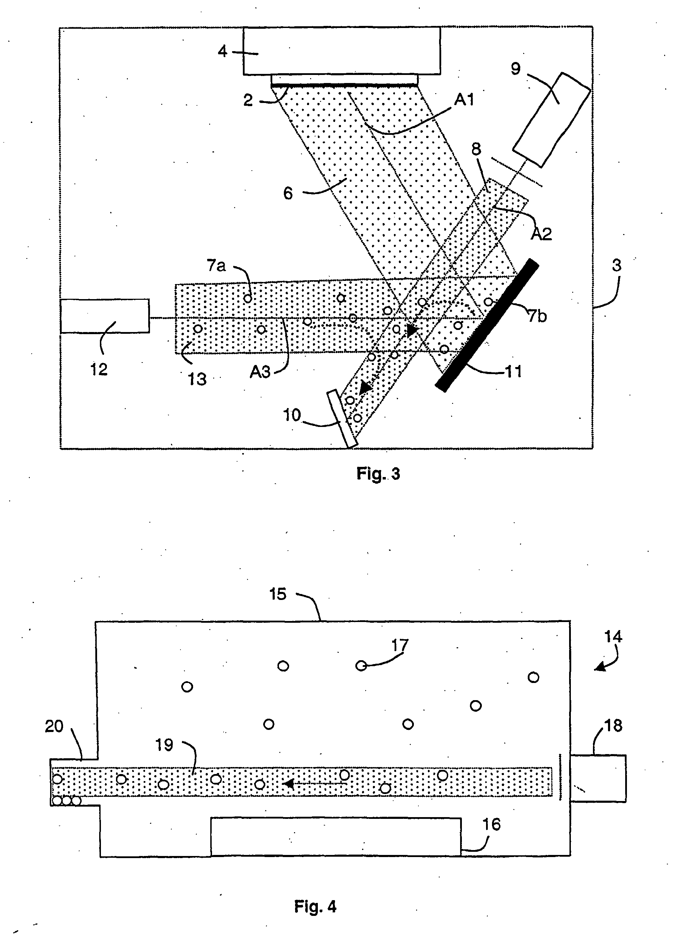

Selon une variante de réalisation représentée à la figure 3, la source ionique 9 formant le plasma écran 8 peut être disposée de sorte que le plasma écran 8 traverse simultanément le plasma de pulvérisation 13 et le flux 6 de matière pulvérisée. Dans ce cas, les particules contaminatrices 7a et 7b provenant respectivement du canon de pulvérisation 12 et de la cible 11 sont respectivement entraînées par le plasma écran 8 selon les flèches représentées en traits pointillés sur la figure 2. Le plasma écran 8 traverse le flux 6 de matière pulvérisée, à proximité de la surface de la cible 11, de sorte que les particules contaminatrices 7b sont, dès leur formation, entraînées vers l'élément collecteur 10, qui est disposé à l'écart du plasma de pulvérisation 13. Dans ce mode de réalisation, l'élément collecteur 10 est éloigné du substrat 2, ce qui présente l'avantage de diminuer le risque de contamination due à la pulvérisation de l'élément collecteur 10 par le plasma 8 faisant écran. L'invention n'est pas limitée aux modes de réalisation décrits ci-dessus

Dans le mode de réalisation représenté à la figure 2 et dans sa variante de réalisation représentée à la figure 3, le dépôt de couches minces est réalisé par pulvérisation IBS. Un tel dépôt peut également être réalisé par pulvérisation cathodique, en remplaçant la cible 11 par une cathode de pulvérisation destinée à être bombardée par le plasma de pulvérisation 13. Le faisceau 8 de particules peut également traverser simultanément le plasma de pulvérisation 13 et le flux de matière pulvérisée issue de la cathode de pulvérisation.

Le fait d'utiliser un faisceau 8 de particules polarisées entraînant les particules contaminatrices à l'écart d'un micro-composant ou d'un substrat, permet d'utiliser les techniques usuelles de dépôts de couches minces, tout en diminuant, de manière simple, efficace et reproductible, le risque de contamination par des particules issues de la source générant la matière destinée à former les couches minces. Ceci peut être appliquée à tout type de micro-composant comportant des couches minces dont le nombre de défauts dus au procédé de dépôt de couches minces doit être très faible. Ainsi, les micro-composants peuvent être des miroirs utilisés en EUV, des composants optiques à haute tenue au flux laser, des couches de protection contre les effets de l'environnement, et notamment les couches anti-corrosion, les couches diélectriques sur circuits imprimés, les couches magnétiques, les couches résistives...

La contamination d'un micro-composant peut également avoir lieu lors de son stockage dans une chambre sous vide. En effet, des particules contaminatrices peuvent provenir du dégazage des parois de la chambre sous vide. Ainsi, comme représenté à la figure 4, un dispositif de stockage 14 mettant en oeuvre un procédé selon l'invention, comporte une chambre sous vide 15 dans laquelle est disposé un micro-composant 16, qui peut être, par exemple, un masque de lithographie EUV. Les parois de la chambre sous vide 15 libèrent des particules polarisées 17 susceptibles de contaminer la surface libre du micro-composant 16. Pour éviter qu'elles ne se déposent sur la surface libre du micro-composant 16, une source 18 émet un faisceau 19 de particules dont au moins une partie a une polarité inverse à celles des particules contaminatrices 17.
Le faisceau 8 de particules est pulvérisé parallèlement et à proximité de la surface du micro-composant 16. Le faisceau 19 de particules est, de préférence formé par un plasma. Ainsi, le faisceau 19 de particules entraîne les particules contaminatrices 17 à l'écart de la surface libre du micro-composant 16 vers un élément collecteur 20, qui peut être un piège à particules. Le micro-composant 16 peut ainsi être stocké dans le dispositif de stockage, sans risque de contamination.

## Revendications

1. Procédé destiné à éviter le dépôt de premières particules (7, 17) polarisées issues d'au moins une source de contamination (5, 11, 13), sur la surface libre d'un micro-composant (16) disposé dans une chambre sous vide (3, 15), procédé **caractérisé en ce qu**'il consiste à pulvériser, entre la source de contamination (5, 11, 13) et le micro-composant (16), un faisceau (8, 19) de secondes particules dont au moins une partie a une polarité inverse à celle des premières particules (7, 17), de manière à entraîner les premières particules (7, 17) à l'écart du micro-composant (16), vers un élément collecteur (10, 20).

2. Procédé selon la revendication 1, **caractérisé en ce que** le faisceau (8, 19) de secondes particules est un plasma.

3. Procédé selon la revendication 2, **caractérisé en ce que** le plasma est réalisé à partir d'un gaz ou d'un mélange de gaz choisis parmi le néon, l'hélium, l'hydrogène, l'argon ou le xénon.

4. Procédé selon l'une des revendications 2 et 3, **caractérisé en ce que** la tension destinée à générer le plasma est comprise entre 50 Volts et 200 Volts.

5. Procédé selon l'une quelconque des revendications 1 à 4, **caractérisé en ce que** le micro-composant comporte un substrat (2) sur lequel est destinée à être déposée au moins une couche mince et **en ce que** les premières particules (7) sont entraînées par un flux (6) de matière pulvérisée destinée à former ladite couche mince, le faisceau (8) de secondes particules traversant le flux (6) de matière pulvérisée en amont du micro-composant.

6. Procédé selon la revendication 5, **caractérisé en ce que** le flux (6) de matière pulvérisée est formé par le bombardement d'une cible (11) par un plasma de pulvérisation (13).

7. Procédé selon la revendication 6, **caractérisé en ce que** le faisceau (8) de secondes particules traverse simultanément le plasma de pulvérisation (13) et le flux (6) de matière pulvérisée.

8. Procédé selon l'une des revendications 6 et 7, **caractérisé en ce que** le dépôt de la couche mince est réalisé par pulvérisation par faisceau d'ions.

9. Procédé selon l'une des revendications 6 et 7, **caractérisé en ce que** le dépôt de la couche mince est réalisé par pulvérisation cathodique.

10. Procédé selon la revendication 5, **caractérisé en ce que** le dépôt de la couche mince est réalisé par évaporation thermique par effet Joule.

11. Dispositif de stockage comportant une chambre sous vide dans laquelle est disposé au moins un micro-composant (16), dispositif **caractérisé en ce qu'**il comporte une source (18) émettant le faisceau (19) de secondes particules parallèlement et à proximité de la surface libre du micro-composant (16) pour la mise en oeuvre du procédé selon l'une quelconque des revendications 1 à 4.

12. Dispositif de dépôt de couches minces comportant une chambre sous vide (3) dans laquelle est disposé un micro-composant comportant au moins un substrat (2) et des moyens de pulvérisation d'un flux (6) de matière destinée à former au moins une couche mince à la surface du micro-composant, **caractérisé en ce qu'**il comporte une source (9) émettant le faisceau (8) de secondes particules en direction du flux (6) de matière, de manière à ce qu'il entraîne les premières particules (7) contenues dans le flux (6), à l'écart du micro-composant, pour la mise en oeuvre du procédé selon l'une quelconque des revendications 5 à 10.

## Claims

1. Process designed to prevent deposition of polarized first particles (7, 17) originating from at least one contamination source (5, 11, 13) on the free surface of a micro-component (16) arranged in a vacuum chamber (3, 15), process **characterized in that** it consists in sputtering a beam (8, 19) of second particles between the contamination source (5, 11, 13) and the micro-component (16), at least a part of which second particles has an opposite polarity from that of the first particles (7, 17), so as to drag the first particles (7, 17) away from the micro-component (16) to a collecting element (10, 20).

2. Process according to claim 1, **characterized in that** the beam (8, 19) of second particles is a plasma.

3. Process according to claim 2, **characterized in that** the plasma is formed by a gas or a mixture of gases chosen from neon, helium, hydrogen, argon or xenon.

4. Process according to one of the claims 2 and 3, **characterized in that** the voltage designed to generate the plasma is comprised between 50 Volts and 200 Volts.

5. Process according to any one of the claims 1 to 4, **characterized in that** the micro-component comprises a substrate (2) whereon at least one thin layer is designed to be deposited, and that the first particles (7) are dragged by a flow (6) of sputtered matter designed to form said thin layer, the beam (8) of second particles passing through the flow (6) of sputtered matter upstream from the micro-component.

6. Process according to claim 5, **characterized in that** the flow (6) of sputtered matter is formed by bombardment of a target (11) by a sputtering plasma (13).

7. Process according to claim 6, **characterized in that** the beam (8) of second particles passes simultaneously through the sputtering plasma (13) and the flow (6) of sputtered matter.

8. Process according to one of the claims 6 and 7, **characterized in that** deposition of the thin layer is performed by ion beam sputtering.

9. Process according to one of the claims 6 and 7, **characterized in that** deposition of the thin layer is performed by cathodic sputtering.

10. Process according to claim 5, **characterized in that** deposition of the thin layer is performed thermal evaporation by Joule effect.

11. Storage device comprising a vacuum chamber wherein there is arranged at least one micro-component (16), device **characterized in that** it comprises a source (18) emitting the beam (19) of second particles parallel to and near the free surface of the micro-component (16) for implementation of the process according to any one of the claims 1 to 4.

12. Thin layer deposition device comprising a vacuum chamber (3) wherein there is arranged a micro-component comprising at least one substrate (2) and means for sputtering a flow (6) of matter designed to form at least one thin layer on the surface of the micro-component, **characterized in that** it comprises a source (9) emitting the beam (8) of second particles in the direction of the flow (6) of matter so that it drags the first particles (7) contained in the flow (6) away from the micro-component, for implementation of the process according to any one of the claims 5 to 10.

## Patentansprüche

1. Verfahren zur Vermeidung von Ablagerungen erster polarisierter Partikel (7, 17), die von mindestens einer Verunreinigungsquelle (5, 11, 13), her stammen, auf der Oberfläche eines Mikrobauteils (16), das in einer unter Vakuum stehenden Kammer (3, 15) angeordnet ist, Verfahren, das **dadurch gekennzeichnet ist, dass** es darin besteht, dass zwischen der Verunreinigungsquelle (5, 11, 13) und dem Mikrobauteil (16) ein Strahl (8, 19) aus zweiten Partikeln zerstäubt wird, von dem mindestens ein Teil eine umgekehrte Polarität zu derjenigen der ersten Partikel (7, 17) hat, um die ersten Partikel (7, 17) mit Abstand zum Mikrobauteil (16) in Richtung auf ein Auffangelement (10, 20) mitzunehmen.

2. Verfahren nach Anspruch 1, **dadurch gekennzeichnet, dass** der Strahl (8, 19) aus zweiten Partikeln Plasma ist.

3. Verfahren nach Anspruch 2, **dadurch gekennzeichnet, dass** das Plasma auf Basis eines Gases oder eines Gasgemischs hergestellt ist, das aus Neon, Helium, Wasserstoff, Argon oder Xenon ausgewählt ist.

4. Verfahren nach einem der Ansprüche 2 und 3, **dadurch gekennzeichnet, dass** die zur Erzeugung des Plasmas bestimmte Spannung 50 bis 200 Volt beträgt.

5. Verfahren nach einem der Ansprüche 1 bis 4, **dadurch gekennzeichnet, dass** das Bauteil ein Substrat (2) umfasst, auf dem mindestens eine dünne Schicht aufgebracht werden soll, sowie dadurch, dass die ersten Partikel (7) von einem Strom (6) aus zerstäubtem Material mitgenommen wird, das die genannte dünne Schicht bilden soll, wobei der Strahl (8) aus zweiten Partikeln den Strom (6) aus zerstäubtem Material vor dem Mikrobauteil durchzieht.

6. Verfahren nach Anspruch 5, **dadurch gekennzeichnet, dass** der Strom (6) aus zerstäubtem Material durch Beschuss einer Prallplatte (11) mit einem Zerstäubungsplasma (13) gebildet wird.

7. Verfahren nach Anspruch 6, **dadurch gekennzeichnet, dass** der Strahl (8) aus zweiten Partikeln gleichzeitig das Zerstäubungsplasma (13) und den Strom (6) aus zerstäubtem Material durchquert.

8. Verfahren nach einem der Ansprüche 6 und 7, **dadurch gekennzeichnet, dass** das Aufbringen der dünnen Schicht mittels lonenstrahlzerstäubung erfolgt.

9. Verfahren nach einem der Ansprüche 6 und 7, **dadurch gekennzeichnet, dass** das Aufbringen der dünnen Schicht mittels Kathodenzerstäubung erfolgt.

10. Verfahren nach Anspruch 5, **dadurch gekennzeichnet, dass** das Aufbringen der dünnen Schicht durch thermisches Aufdampfen mittels Joulescher Wärme erfolgt.

11. Lagerungsvorrichtung, die eine Vakuumkammer umfasst, in der mindestens eine Mikrobauteil (16) angeordnet ist, Vorrichtung, die **dadurch gekennzeichnet, dass** sie zur Anwendung des Verfahrens nach einem der Ansprüche 1 bis 4 eine Quelle (18) umfasst, die den Strahl (19) aus zweiten Partikeln parallel und nahe zu der freien Oberfläche des Mikrobauteils (16) aussendet.

12. Vorrichtung zum Aufbringen dünner Schichten, die eine Vakuumkammer (3) umfasst, in der ein Mikrobauteil angeordnet ist, das mindestens ein Substrat (2) und Mittel zur Zerstäubung eines Stroms (6) aus einem Material umfasst, das dazu bestimmt ist, auf der Oberfläche des Mikrobauteils mindestens eine dünne Schicht zu bilden, **dadurch gekennzeichnet, dass** sie zur Anwendung des Verfahrens nach einem der Ansprüche 5 bis 10 eine Quelle (9) umfasst, die den Strahl (8) aus zweiten Partikeln in Richtung auf den Materialstrom (6) aussendet, in der Weise, dass er die in dem Strom (6) enthaltenen ersten Partikel (7) mit Abstand zum Mikrobauteil mit sich nimmt.
